(19) **Europäisches Patentamt / European Patent Office / Office européen des brevets**

(11) **EP 4 343 021 A1**

(12) # EUROPEAN PATENT APPLICATION
published in accordance with Art. 153(4) EPC

(43) Date of publication:
**27.03.2024  Bulletin 2024/13**

(21) Application number: **23821858.0**

(22) Date of filing: **15.05.2023**

(51) International Patent Classification (IPC):
**C23C 16/42** $^{(2006.01)}$    **C01B 32/977** $^{(2017.01)}$

(52) Cooperative Patent Classification (CPC):
**C01B 32/977; C23C 16/42**

(86) International application number:
**PCT/JP2023/018125**

(87) International publication number:
**WO 2024/024218 (01.02.2024 Gazette 2024/05)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **26.07.2022  JP 2022118431**

(71) Applicant: **Tokai Carbon Co., Ltd.**
**Minato-ku**
**Tokyo 107-8636 (JP)**

(72) Inventors:
• **SUGIHARA, Takaomi**
  **Tokyo 107-8636 (JP)**
• **USHIJIMA, Yuji**
  **Tokyo 107-8636 (JP)**

(74) Representative: **Eisenführ Speiser**
**Patentanwälte Rechtsanwälte PartGmbB**
**Postfach 10 60 78**
**28060 Bremen (DE)**

(54) **POLYCRYSTALLINE SIC MOLDED ARTICLE AND METHOD FOR PRODUCING SAME**

(57)  The present invention provides a polycrystalline SiC formed body having a low resistivity and a small variation in resistivity in a thickness direction thereof, and a method for producing the same. In the polycrystalline SiC formed body, a resistivity is 0.050 $\Omega$cm or less, and an average value of peak intensity ratios (A/B) is 0.040 or less, and a difference between an average of peak intensity ratios on a growth surface side and an average of peak intensity ratios on a substrate surface side is 0.040 or less, wherein "A" represents a peak intensity within a range of wavenumber of 950 to 970 $cm^{-1}$ of a Raman spectrum and "B" represents a peak intensity within a range of wavenumber of 780 to 800 $cm^{-1}$ in a Raman spectrum.

FIG.2

EP 4 343 021 A1

**Description**

[Technical Field]

The present invention relates to a polycrystalline SiC formed by a CVD-SiC and a method for producing the same.

[Background Art]

A polycrystalline SiC formed body is excellent in various properties such as heat resistance, corrosion resistance, and strength and is used in various usages. A polycrystalline SiC formed body is obtained by precipitating polycrystalline SiC on a surface of a substrate by the CVD method to form a film, and then removing the substrate.

For example, Patent Literature 1 describes that a polycrystalline SiC formed body is used for members for semiconductor production devices and members for etching devices, CVD devices, and the like.

[Citation List]

[Patent Literature]

[Patent Literature 1] Japanese Patent Application Publication No. 2014-31527

[Summary of Invention]

A polycrystalline SiC formed body is required to have various properties depending on its usages.

For example, as described in Patent Literature 1, in the case of using a polycrystalline SiC formed body as a member for plasma etching, it is necessary for the polycrystalline SiC formed body to have a low resistivity and a uniform resistivity in order to release static electricity and uniformly generate a plasma gas.

The present invention has an object to stably supply a member for semiconductor production devices which has a low resistivity and a uniform resistivity. Conventionally, there has been a case where a polycrystalline SiC formed body has variations in resistivity in the thickness direction of a polycrystalline SiC formed body, and cannot exert sufficient performances as a polycrystalline SiC formed body.

Specifically, a method of measurement using the four-terminal method or the four probe method has allowed evaluation in a macro-level region of mm to several tens of mm levels, but it is even currently very difficult to directly find a resistance distribution in the thickness direction at micron level.

On the other hand, Raman spectrum enables to evaluate distribution at micron level, and even though variations in resistivity are small in the conventional CVD-SiC, it was found that the variations are sufficiently large at micron level. Variations in resistivity in the thickness direction cause a reduction in throughput of the device because the resistivity in the surface of the member varies and causes a necessity to adjust the driving condition of the device. From such viewpoint, a member for semiconductor production devices having a low resistivity and a uniform resistivity in the thickness direction has been desired.

In view of this, an object of the present invention is to provide a polycrystalline SiC formed body that has a low resistivity and has a small variation in resistivity in a thickness direction and a method for producing the same.

In order to achieve the above-described object, the present invention includes the following matters.

[1] A polycrystalline SiC formed body, wherein

a resistivity is 0.050 $\Omega$cm or less, and
an average of peak intensity ratios (A/B) is 0.040 or less, and a difference between an average of peak intensity ratios on a growth surface side and an average of peak intensity ratios on a substrate surface side is 0.040 or less, wherein "A" represents a peak intensity within a range of wavenumber of 950 to 970 cm$^{-1}$ in a Raman spectrum and "B" represents a peak intensity within a range of wavenumber of 780 to 800 cm$^{-1}$ in a Raman spectrum.

[2] The polycrystalline SiC formed body according to [1], wherein
a content of nitrogen is 200 ppm (mass parts per million) or more.

[3] A method for producing the polycrystalline SiC formed body according to [1] or [2] by using a CVD method comprising:

introducing a nitrogen atom-containing compound gas together with a raw material gas and a carrier gas into a reaction chamber; and
increasing a concentration of the nitrogen atom-containing compound gas at a constant rate from a start of film formation to an end of the film formation.

[4] The method for producing a polycrystalline SiC formed body according to [3], wherein
a rate of increase of a flow rate of the nitrogen atom-containing compound gas from the start of the film formation to the end of the reaction is 1.0%/hr or more and 10.0%/hr or less.

The present invention makes it possible to provide a polycrystalline SiC formed body having a low resistivity and a small variation in resistivity in a thickness direction, and a method for producing the same.

[Brief Description of Drawings]

[Fig. 1] Fig. 1 is a schematic diagram showing an example of a manufacturing system used in a method for producing a polycrystalline SiC substrate.
[Fig. 2] Fig. 2 is a schematic sectional view showing a radial section of a disk-shaped graphite substrate 2 on which a polycrystalline SiC film 4 has been formed.
[Fig. 3] Fig. 3 is a schematic sectional view showing a radial section of the graphite substrate 2 on which the polycrystalline SiC film 4 is formed, which is obtained by cutting a thickness of the disk-shaped graphite substrate 2 into half after the polycrystalline SiC film 4 on an outer periphery of the disk has been removed.

[Description of Embodiments]

Hereinafter, an embodiment of the present invention will be described in detail with reference to the drawings. The detailed description of the present invention given below is one of illustrations of embodiments, and the present invention should not be construed to be limited to the present embodiment at all.

The polycrystalline SiC formed body may be plate-shaped, and a plate-shaped polycrystalline SiC formed body has a thickness that allows the plate-shaped polycrystalline SiC formed body to be easily handled, and for example, has a thickness of around 300 to 5000 $\mu$m.

In addition, the polycrystalline SiC formed body may be tube-shaped, and a tube-shaped polycrystalline SiC formed body has a thickness that allows the tube-shaped polycrystalline SiC formed body to be easily handled, and for example, has a thickness of around 300 to 5000 $\mu$m.

The polycrystalline SiC formed body has a resistivity of 0.050 $\Omega$cm or less. Having such a resistivity makes it easy to remove static electricity in a semiconductor production device. In addition, from the viewpoint of ensuring a stable driving of a semiconductor production device, the resistivity of the polycrystalline SiC formed body is preferably 0.030 $\Omega$cm or less, and further preferably 0.020 $\Omega$cm or less. The resistivity can be adjusted, for example, by causing the polycrystalline SiC formed body to contain a predetermined amount of nitrogen. The resistivity can be lowered by increasing the content of nitrogen.

The content of nitrogen of the polycrystalline SiC formed body is, for example 200 ppm (mass parts per million) or more, and preferably 200 to 1000 ppm (mass parts per million). In the case where the content of nitrogen is within such a range, the degree of change in resistivity relative to a change in content of nitrogen becomes small. Hence, by controlling the content of nitrogen, it becomes easy to obtain a desired resistivity. In addition, if the content of nitrogen is 1000 ppm (mass parts per million) or less, crystal defects generated by introduction of nitrogen hardly affect the properties.

Note that the method for introducing nitrogen is not particularly limited. For example, it is possible to introduce nitrogen into a polycrystalline SiC film to be formed, by using a nitrogen atom-containing compound gas at the time of forming the polycrystalline SiC film by a CVD method, as described later.

The polycrystalline SiC formed body has a predetermined crystalline structure. Specifically, in a Raman spectrum obtained from the polycrystalline SiC formed body, an average value of ratios (A/B) between a peak intensity "A" and a peak intensity "B" is 0.040 or less.

Here, the peak intensity "A" is an intensity (maximum value) of a peak within a range of wavenumber of 950 to 970 cm$^{-1}$ in Raman spectrum. This peak is known as the LO (longitudinal optical phonon) peak of a polycrystalline SiC material, and decreases with an increase in the stacking fault (the same applies to $N_2$ content) to be shifted to a broad band, from which it is thus said to be possible to evaluate the concentration of the carrier.

On the other hand, the peak intensity "B" is an intensity (maximum value) of a peak within a range of wavenumber of 780 to 800 cm$^{-1}$ in the Raman spectrum. This peak is known as the TO (transverse optical phonon) peak of a polycrystalline SiC material, and is a peak observed at the maximum intensity in 3C-SiC. In 3C-SiC, only the peak intensity and A and B are observed.

The conditions that the average value of the peak intensity ratios (A/B) is 0.040 or less and a difference between the average of the peak intensity ratios on the growth surface side and the average value of the peak intensity ratios on the substrate surface side is 0.040 or less mean that the polycrystalline SiC has a low resistivity (that is, the smaller the peak intensity ratio (A/B), the lower the resistance), and also that a variation in resistivity in the thickness direction is sufficiently small. If the average value of the peak intensity ratios (A/B) is 0.040 or less and the difference between the average of the peak intensity ratios on the growth surface side and the average of the peak intensity ratios on the substrate surface side is 0.040 or less, a low-resistive polycrystalline SiC formed body having a small variation in resistivity in the thickness direction is provided.

Note that regarding a polycrystalline SiC formed body that has a low resistivity and a small variation in resistivity in the thickness direction, the average value of the peak intensity ratio (A/B) is more preferably 0.020 or less and the difference between the average of the peak intensity ratios on the growth surface side and the average of the peak intensity ratios on the substrate surface side is more preferably 0.020 or less, from the viewpoint of ensuring the stability of the driving condition when the polycrystalline SiC formed body is used as a member for semiconductor production devices.

Conventionally, a method for measuring a resistivity is in compliance with JIS K7194, in which a test piece having a longitudinal side of 10 mm×a transverse side of 10 mm×a thickness of 0.3 to 1.0 mm is processed from a polycrystalline SiC formed body, and the resistivity is obtained from an electrical resistance measured by the four probe method. As can be seen from the size of the test piece, a resistivity obtained in this way indicates an average resistivity of a bulk body having a mm size. Even when the measurement region is narrowed by reducing the size of a sample, the resistance value itself is measured as an average value even if there is a defect or the like in the polycrystalline SiC formed body.

On the other hand, it was found that in the case of measurement using Raman spectrum, it is possible to measure an irradiation diameter in such a very narrow micro range as 2 $\mu$m.

That is, it can be easily imagined that even conventional ones that are said to have uniform resistivities microscopically have non-uniform resistivities, and as a result, there are cases where performances cannot be exerted or many defects are included in a member for semiconductor production devices particularly in usages that require low resistivities and uniform distribution of resistivities in the thickness direction.

Subsequently, a method for producing a polycrystalline SiC formed body will be described. A polycrystalline SiC formed body having properties as described above can be produced by employing a specific production method using the CVD method as described below.

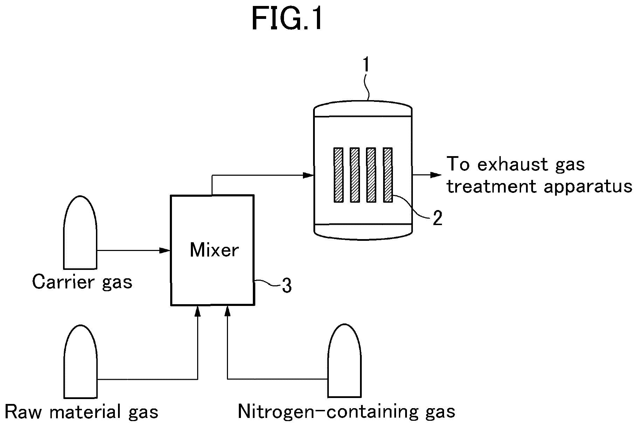

Fig. 1 is a schematic diagram showing an example of a manufacturing system used in the method for producing a polycrystalline SiC formed body according to the present embodiment. This manufacturing system includes a CVD furnace 1 and a mixer 3. In the mixer 3, a carrier gas, a raw material gas serving as a supply source of SiC, and a nitrogen atom-containing compound gas are mixed to generate a mixed gas. The mixed gas is supplied from the mixer 3 to the CVD furnace 1. In the CVD furnace 1, a plurality of graphite substrates 2 are disposed. Each of these graphite substrates 2 is disk-shaped or tube-shaped. When the mixed gas is supplied to the CVD furnace 1, a polycrystalline SiC film 4 is formed on each graphite substrate 2 by the CVD method. In addition, the polycrystalline SiC film is doped with nitrogen derived from the nitrogen atom-containing compound gas. This polycrystalline SiC film is made into a polycrystalline SiC formed body by separating this polycrystalline SiC film 4 from the graphite substrate 2 or removing the graphite substrate 2 from the polycrystalline SiC film 4, followed by grinding or polishing.

Note that as the raw material gas, which serves as the supply source of SiC, one component-based gas (gas containing Si and C) or two component-based gas (gas containing Si and gas containing C) may be used.

The film thickness of the polycrystalline SiC film to be formed is, for example 500 to 6000 $\mu$m, and preferably 450 to 5500 $\mu$m.

The carrier gas to be used in the film formation is not particularly limited, but hydrogen gas or the like may be used, for example.

The raw material gas is not particularly limited as long as the gas contains the supply source of Si and C. For example, a gas containing Si and C in a molecule, a mixed gas of a gas containing Si in a molecule and a hydrocarbon gas, or the like may be used.

The raw material gas includes, for example, methyltrichlorosilane, trichlorophenylsilane, dichloromethylsilane, dichlorodimethylsilane, chlorotrimethylsilane and the like in the case of a one component-based gas. In addition, the raw material gas includes a mixture of a silane-containing gas such as trichlorosilane or monosilane and a hydrocarbon gas, and the like in the case of the two component-based gas.

Specific conditions for the film formation by the CVD method are not particularly limited, but, for example, the following conditions may be employed.

The gas residence time in the CVD furnace is, for example, 10 to 200 seconds, and preferably 20 to 100 seconds.

The reaction temperature is, for example 1100 to 1900°C, and preferably 1400 to 1600°C.

The flow rate of the nitrogen atom-containing compound gas is, for example, 5 to 100 vol%, and preferably 10 to 70 vol% relative to the total flow rate of the flow rate of the raw material gas and the flow rate of the carrier gas.

Note that a rate of increase of the flow rate of the nitrogen atom-containing compound gas from the start of the film formation to the end of the film formation is preferably 1.0 to 10.0%/hr, and preferably 2.50 to 7.50%/hr to stably obtain the polycrystalline SiC formed body, and preferably 4.0 to 6.0%/hr to more stably obtain the polycrystalline SiC formed body from the viewpoint of suppressing variations in resistivity of the polycrystalline SiC formed body in the thickness direction.

This is because in an early stage of the film formation, the grain size is fine and there are many grain boundaries, while in an ending stage of the film formation, the grain size grows, so that grain boundaries become fewer. That is, since nitrogen is solid-dissolved preferentially in grain boundaries, in the early stage of the film formation where there are many grain boundaries, solid-dissolved nitrogen increases, while in the ending stage of the film formation, solid-dissolved nitrogen decreases. Hence, while the Raman peak intensity ratio on the substrate surface side which becomes a surface in the early stage of the film formation has a low resistivity, the Raman peak intensity ratio on the growth surface side which becomes a surface in the ending stage of the film formation has a high resistivity. In this way, there occur variations in resistivity of the polycrystalline SiC formed body in the thickness direction.

By increasing the flow rate of the nitrogen atom-containing compound gas from the early stage of the film formation toward the ending stage of the film formation, the amount of present nitrogen increases to increase solid-dissolved nitrogen. As a result, it becomes possible to make solid-dissolved nitrogen into a certain range from the early stage of the film formation to the end stage, thus making it possible to reduce variations in resistivity in the thickness direction.

In addition, for example, in the case where the raw material gas is a gaseous raw material, it is possible to adjust the raw material gas concentration by controlling the flow rate of the raw material gas and the flow rate of the carrier gas. In addition, in the case where the raw material gas is a gas derived from a liquid raw material, it is possible to adjust the raw material gas concentration by controlling the temperature of the liquid raw material in the raw material tank to control the vapor pressure of the liquid raw material.

After the film forming step of the polycrystalline SiC film by the CVD method is ended, each graphite substrate 2 on which the polycrystalline SiC film 4 has been formed is taken out of the CVD furnace 1, and thereafter, is processed to take out only a polycrystalline SiC formed body as necessary.

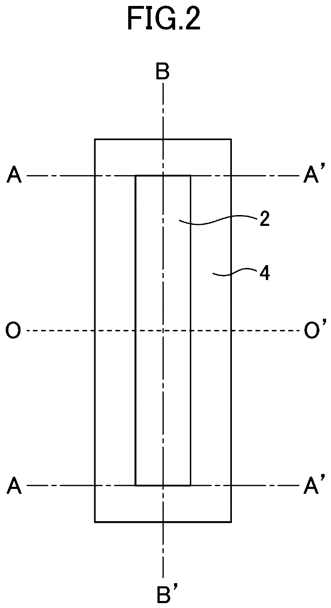

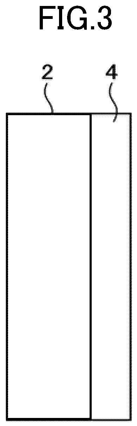

Fig. 2 is a schematic diagram showing a radial section of a disk-shaped graphite substrate 2 having a center line O-O' on which the polycrystalline SiC film 4 has been formed. Here, the graphite substrate 2 has the polycrystalline SiC film 4 formed in such a manner as to cover the entire surface of the graphite substrate 2. For example, the graphite substrate 2 on which the polycrystalline SiC film 4 has been formed is first subjected to outer periphery processing. Specifically, only an outer peripheral portion of the graphite substrate 2 on which the polycrystalline SiC film 4 has been formed is cut and removed along a break line A-A' shown in Fig. 2. Subsequently, the graphite substrate 2 on which the polycrystalline SiC film 4 has been formed is cut into half in the thickness direction along a line in which the thickness of the graphite substrate 2 is divided into half, that is, a break line B-B' which is shown in Fig. 2. As a result, as shown in Fig. 3, a stacked body of the graphite substrate 2 and the polycrystalline SiC film 4 is obtained. Moreover, subsequently, only the graphite substrate 2 is removed from the stacked body by oxidation, a shot blasting method, or the like. Thereafter, an exposed surface of the polycrystalline SiC film 4, which has been exposed by the removal of the graphite substrate 2, is ground by a grinding process or the like. A polycrystalline SiC formed body can be obtained by the processing method described above.

As described above, since the content of nitrogen is controlled to be a predetermined value in the thickness direction of a polycrystalline SiC formed body by increasing the nitrogen atom-containing compound gas at a constant rate in forming a polycrystalline SiC film by the CVD method, the present embodiment makes it possible to obtain a polycrystalline SiC formed body having a low resistivity and a small variation in resistivity in the thickness direction.

Note that since the present embodiment makes it possible to obtain a polycrystalline SiC formed body having a low resistivity and a small variation in resistivity in the thickness direction, the present embodiment is favorable in the usage of a member for semiconductor production devices. However, the polycrystalline SiC formed body according to the present embodiment can also be favorably used in other usages as long as the usages require a low resistivity and small variation in resistivity in the thickness direction.

For example, the polycrystalline SiC formed body according to the present embodiment can be used for an edge ring, an electrode plate and a heater as a member for plasma etching device in production of semiconductor. In addition, the polycrystalline SiC formed body according to the present embodiment can be used for a dummy wafer as a member for semiconductor thermal processing devices in production of semiconductor.

Note that in the case of using the polycrystalline SiC formed body as an edge ring or an electrode plate, the polycrystalline SiC formed body has a thickness of around 1000 to 5000 $\mu$m, for example. In addition, in the case of using the polycrystalline SiC formed body as a dummy wafer, the polycrystalline SiC formed body has a thickness of around 300 to 1500 μm, for example.

[Examples]

(Example 1)

A graphite substrate having a diameter of 160 mm and a thickness of 5 mm was placed in a CVD furnace. Methyltrichlorosilane (raw material gas), hydrogen (carrier gas), and a nitrogen gas were introduced into the CVD furnace to form a polycrystalline SiC film on the graphite substrate at 1500°C for 10 hours. Conditions for the film formation are shown in Table 1.

The gas residence time was 33.1 (seconds) at the time of the start of the film formation and was 32.0 (seconds) at the time of the end of the film formation. Note that the gas residence time was calculated in accordance with the following formula:

$$\text{(Formula 1): gas residence time (seconds)=(furnace inner volume/gas flow rate)}\times((20+273)/(\text{reaction temperature}+273))\times60.$$

After the film formation, the graphite substrate was taken out of the CVD furnace and subjected to outer periphery processing and separation processing. Moreover, the graphite substrate was removed to obtain a polycrystalline SiC formed body having a diameter of 150 mm and a thickness of 0.6 mm. Furthermore, flat surface grinding processing was conducted to obtain a polycrystalline SiC formed body having a diameter of 150 mm and a thickness of 0.5 mm.

At this time, the surface in contact with the graphite substrate was referred to as the substrate surface side, and the opposite surface was referred to as the growth surface side. The flat surface on the substrate surface side and the flat surface on the opposite growth surface side were minimally ground such that the diameter of 150 mm appeared in the entire surfaces to adjust the thickness to 0.5 mm. This was obtained as a polycrystalline SiC formed body according to Example 1.

(Examples 2 to 7, and Comparative Examples 1 to 2)

Polycrystalline SiC formed bodies according to Examples 2 to 7 and Comparative Examples 1 to 2 were obtained by using the same method as in Example 1. However, conditions for the film formation were changed as described in Table 1. Note that the nitrogen gas flow rate was made constant (70 L/min) in Comparative Example 1.

(Measurement of Resistivity)

The polycrystalline SiC formed body obtained in each of Examples and Comparative Examples was processed into a test piece having a longitudinal side of 10 mm×a transverse side of 10 mm×a thickness of 0.3 to 1.0 mm and the resistivity was measured by the four probe method. For the measurement of the resistivity, Loresta GP MCT-T610 manufactured by Mitsubishi Chemical Analytech Co., Ltd. in compliance with JIS K7194 was used.

(Measurement of Raman Spectrum)

The Raman spectrum of each obtained polycrystalline SiC formed body was measured under the following conditions by using a microscopic Raman spectroscopy device LabRAM HR800 manufactured by Horiba, Ltd.

    Excitation wavelength: 532 nm
    Irradiation diameter: φ 2μm
    Exposure time: 15 seconds
    Cumulated number: 2
    Grating: 1800 gr/mm

In the Raman spectrum thus obtained, with an average value of spectrum intensities within a range of wavenumber of 810 to 940 $cm^{-1}$ as a background correction value, the maximum spectrum intensity within a range of wavenumber of 950 to 970 $cm^{-1}$ was obtained as the "peak A (before correction)" and the maximum spectrum intensity within a range of wavenumber of 780 to 800 $cm^{-1}$ was obtained as a "peak B (before correction)". The peak A and the peak B were obtained by subtracting the background correction value from the respective peak intensities (before correction).

Then, the peak intensity ratio (A/B) was calculated. Here, in the case where the peak A (before correction) was smaller than the background correction value, the peak A was counted as 0. The average value of the peak intensity ratios (A/B) was obtained by measuring peak intensity ratios at 5 points on the substrate surface side and peak intensity ratios at 5 points on the growth surface side, and obtaining an arithmetic mean of the 10 points. The difference between the average of the peak intensity ratios (A/B) on the growth surface and the average of the peak intensity ratios on the substrate surface was obtained by measuring peak intensity ratios at 5 points on the substrate surface side and peak intensity ratios at 5 points on the growth surface side, and subtracting a smaller value from a larger value of the arithmetic means.

(Measurement of Content of Nitrogen)

The content of nitrogen in each polycrystalline SiC formed body was measured by using SIMS-4000 manufactured by ATOMIKA.

(Consideration of Results)

The settings of various gas flow rates, raw material gas concentrations, reaction times, rate of increases in nitrogen gas flow rate are shown in Table 1, and resistivities, nitrogen concentrations in SiC, average values and differences and average values on the substrate surface side and the growth surface side of peak intensity ratios of Raman spectra are shown in Table 2.

Examples 1 to 7 had smaller average values of peak intensity ratios of Raman spectra and smaller differences in peak intensity ratio between the substrate surface side and the growth surface side than Comparative Examples 1 and 2. The average values of Raman spectra of Examples 1 to 7 were smaller than 0.040, and the differences in peak intensity ratio between the substrate surface side and the growth surface side thereof were smaller than 0.040. On the other hand, the average values of peak intensity ratios of Raman spectra in Comparative Examples 1 and 2 were 0.050 or more, and differences in peak intensity ratio between the substrate surface side and the growth surface side of the Raman spectra were 0.080 or more. It was thus understood that variations in resistivity of polycrystalline SiC substrates in the thickness direction were small because the differences in peak intensity ratio between the substrate surface side and the growth surface side of Raman spectra were 0.040 or less.

[Table 1]

| | Flow rate of raw material gas (L/min) | Flow rate of carrier gas (L/min) | Concentration of raw material gas (%) | Flow rate of nitrogen gas at the time of the start of the film formation (L/min) | Flow rate of nitrogen gas at the time of the end of the film formation (L/min) | Reaction time (hr) | Rate of increase of flow rate of nitrogen gas (%/hr) |
|---|---|---|---|---|---|---|---|
| Example 1 | 10.50 | 129.50 | 7.50% | 70.0 | 74.0 | 10 | 0.6% |
| Example 2 | 10.50 | 129.50 | 7.50% | 70.0 | 82.0 | 10 | 1.7% |
| Example 3 | 10.50 | 129.50 | 7.50% | 70.0 | 87.5 | 10 | 2.5% |
| Example 4 | 10.50 | 129.50 | 7.50% | 70.0 | 105.0 | 10 | 5.0% |
| Example 5 | 10.50 | 129.50 | 7.50% | 70.0 | 122.5 | 10 | 7.5% |
| Example 6 | 10.50 | 129.50 | 7.50% | 70.0 | 130.0 | 10 | 8.6% |
| Example 7 | 10.50 | 129.50 | 7.50% | 70.0 | 140.0 | 10 | 10.0% |
| Comparative Example 1 | 10.50 | 129.50 | 7.50% | 70.0 | 70.0 | 10 | 0.0% |
| Comparative Example 2 | 10.50 | 129.50 | 7.50% | 70.0 | 52.5 | 10 | -2.5% |

[Table 2]

| | Concentration of nitrogen in SiC (ppm) | Resistivity (Ωcm) | Average values of Raman peak intensity ratios | | | |
|---|---|---|---|---|---|---|
| | | | Substrate surface side | Growth surface side | Average value of substrate surface side and growth surface side | Difference between substrate surface side and growth surface side |
| Example 1 | 340 | 0.027 | 0.006 | 0.036 | 0.021 | 0.030 |
| Example 2 | 530 | 0.017 | 0.009 | 0.000 | 0.005 | 0.009 |
| Example 3 | 640 | 0.015 | 0.008 | 0.000 | 0.004 | 0.008 |
| Example 4 | 760 | 0.012 | 0.006 | 0.000 | 0.003 | 0.006 |
| Example 5 | 880 | 0.007 | 0.002 | 0.000 | 0.001 | 0.002 |
| Example 6 | 960 | 0.006 | 0.001 | 0.000 | 0.001 | 0.001 |
| Example 7 | 1150 | 0.001 | 0.000 | 0.013 | 0.007 | 0.013 |
| Comparative Example 1 | 320 | 0.033 | 0.009 | 0.090 | 0.050 | 0.081 |
| Comparative Example 2 | 280 | 0.040 | 0.010 | 0.100 | 0.055 | 0.090 |

[Industrial Applicability]

The present invention makes it possible to provide a polycrystalline SiC formed body having a low resistivity and a small variation in resistivity in a thickness direction and a method for producing the same.

[Reference Signs List]

1 CVD furnace

2 graphite substrate

3 mixer

4 polycrystalline SiC film

**Claims**

1.    A polycrystalline SiC formed body, wherein

a resistivity is 0.050 Ωcm or less, and
an average of peak intensity ratios (A/B) is 0.040 or less, and a difference between an average of peak intensity ratios on a growth surface side and an average of peak intensity ratios on a substrate surface side is 0.040 or less, wherein "A" represents a peak intensity within a range of wavenumber of 950 to 970 cm$^{-1}$ in a Raman spectrum and "B" represents a peak intensity within a range of wavenumber of 780 to 800 cm$^{-1}$ in a Raman spectrum.

2.    The polycrystalline SiC formed body according to claim 1, wherein
a content of nitrogen is 200 ppm (mass parts per million) or more.

3.    A method for producing the polycrystalline SiC formed body according to claim 1 or 2 by using a CVD method comprising:

introducing a nitrogen atom-containing compound gas together with a raw material gas and a carrier gas into a reaction chamber; and

increasing a concentration of the nitrogen atom-containing compound gas at a constant rate from a start of film formation to an end of the film formation.

4. The method for producing a polycrystalline SiC formed body according to claim 3, wherein

a rate of increase of a flow rate of the nitrogen atom-containing compound gas from the start of the film formation to the end of the reaction is 1.0%/hr or more and 10.0%/hr or less.

# FIG.1

To exhaust gas
treatment apparatus

Carrier gas

Mixer

Raw material gas                Nitrogen-containing gas

# FIG.2

# FIG.3

## INTERNATIONAL SEARCH REPORT

| | International application No. |
|---|---|
| | **PCT/JP2023/018125** |

### A. CLASSIFICATION OF SUBJECT MATTER

***C23C 16/42***(2006.01)i; ***C01B 32/977***(2017.01)i
FI: C23C16/42; C01B32/977

According to International Patent Classification (IPC) or to both national classification and IPC

### B. FIELDS SEARCHED

Minimum documentation searched (classification system followed by classification symbols)

C23C16/42; C01B32/977; C30B29/36

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2021-54667 A (TOKAI CARBON CO., LTD.) 08 April 2021 (2021-04-08) entire text, all drawings | 1-4 |
| A | JP 2012-136375 A (TOYO TANSO KK) 19 July 2012 (2012-07-19) entire text, all drawings | 1-4 |
| A | JP 2021-82765 A (SUMITOMO METAL MINING CO) 27 May 2021 (2021-05-27) entire text, all drawings | 1-4 |

☐ Further documents are listed in the continuation of Box C.  ☑ See patent family annex.

| | |
|---|---|
| \* Special categories of cited documents: <br> "A" document defining the general state of the art which is not considered to be of particular relevance <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **19 July 2023** | **01 August 2023** |

| Name and mailing address of the ISA/JP | Authorized officer |
|---|---|
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

International application No.

**PCT/JP2023/018125**

| Patent document cited in search report | | | Publication date (day/month/year) | Patent family member(s) | | | Publication date (day/month/year) |
|---|---|---|---|---|---|---|---|
| JP | 2021-54667 | A | 08 April 2021 | US | 2022/0341054 | A1 | |
| | | | | EP | 4036286 | A1 | |
| | | | | CN | 114430782 | A | |
| | | | | KR | 10-2022-0074864 | A | |
| JP | 2012-136375 | A | 19 July 2012 | US | 2013/0269596 | A1 | |
| | | | | EP | 2657377 | A1 | |
| | | | | TW | 201227805 | A | |
| | | | | CN | 103270203 | A | |
| | | | | KR | 10-2013-0132873 | A | |
| JP | 2021-82765 | A | 27 May 2021 | (Family: none) | | | |

Form PCT/ISA/210 (patent family annex) (January 2015)

**EP 4 343 021 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014031527 A